(19) Europäisches Patentamt
European Patent Office
Office européen des brevets

(11) **EP 2 503 019 A1**

(12) # EUROPEAN PATENT APPLICATION
published in accordance with Art. 153(4) EPC

(43) Date of publication:
**26.09.2012 Bulletin 2012/39**

(21) Application number: **10831337.0**

(22) Date of filing: **18.11.2010**

(51) Int Cl.:
*C23C 14/34* (2006.01)   *C04B 35/00* (2006.01)
*H01L 21/363* (2006.01)

(86) International application number:
**PCT/JP2010/006761**

(87) International publication number:
**WO 2011/061938 (26.05.2011 Gazette 2011/21)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **19.11.2009 JP 2009264086**

(71) Applicant: **Idemitsu Kosan Co., Ltd.**
**Chiyoda-ku**
**Tokyo 100-8321 (JP)**

(72) Inventors:
• **ITOSE, Masayuki**
  **Sodegaura-shi**
  **Chiba 299-0293 (JP)**
• **YANO, Koki**
  **Sodegaura-shi**
  **Chiba 299-0293 (JP)**

(74) Representative: **Gille Hrabal**
**Patentanwälte**
**Brucknerstrasse 20**
**40593 Düsseldorf (DE)**

(54) **In-Ga-Zn-O-BASED OXIDE SINTERED BODY SPUTTERING TARGET WITH EXCELLENT STABILITY DURING LONG-TERM DEPOSITION**

(57)     A sputtering target including an oxide sintered body including In, Zn and Ga, wherein a surface compound and an interior compound are essentially of the same crystal type(s).

FIG.1

EP 2 503 019 A1

**Description**

Technical Field

The invention relates to a sputtering target for forming an oxide thin film such as an oxide semiconductor or a transparent conductor film. In particular, the invention relates to a sputtering target for forming a thin film transistor.

Background Art

An amorphous oxide film composed of indium oxide and zinc oxide or composed of indium oxide, zinc oxide and gallium oxide has transparency to visible rays, and has a wide variety of electric properties as a conductor, a semiconductor or an insulator. Therefore, such an amorphous film has attracted attention as a transparent conductor film or a semiconductor film (used in a thin film transistor or the like).

As the method for forming this oxide film, a physical film-forming method such as sputtering, PLD (pulse laser deposition) and deposition or a chemical film-forming method such as the sol-gel method has been studied. A physical film-forming method such as the sputtering method has been mainly studied since it is a method which can form a film in a large area uniformly at relatively low temperatures.

In order to form an oxide thin film by a physical film-forming method such as sputtering, in order to form a homogenous film stably and efficiently (at a high film-forming speed), a target formed of an oxide sintered body is generally used.

As representative oxide films (conductor films/semiconductor films), an oxide film formed of indium oxide, zinc oxide and gallium oxide can be given. As a target for forming these oxide films (normally, an amorphous film), the composition of a known crystal type such as $InGaZnO_4$ and $In_2Ga_2ZnO_7$ or a composition close to this composition has been mainly studied.

For example, Patent Document 1 discloses a target composed of a homologous crystal structure represented by $InGaZnO_4(InGaO_3(ZnO))$. Further, in Patent Document 2, studies have been made on a production method in which a highly insulating $Ga_2O_3$ crystal phase is not generated. Patent Documents 3 and 4 disclose a sputtering target composed mainly of ZnO. Studies are only made on a sputtering target for use in a photo-recording medium and a transparent electrode. Effects on transistor properties when a thin film transistor is formed by using such a target were not studied. In Patent Document 5, studies are made on the target utilizing properties of a mixture; for example, a target formed of a hexagonal layer compound such as $InGaZnO_4$ and a spinel compound such as $ZnGa_2O_4$. However, in these documents, properties of the crystal type on the surface or in the deep part of the target were not yet studied. In addition, allowing these crystal types to coincide with each other was not yet been studied.

In Patent Document 6, an example is disclosed in which an amorphous oxide semiconductor film and a thin film transistor were formed by using an In-Ga-Zn-O sintered body having a metal composition ratio In: Ga: Zn = 30: 15: 55. However, no studies were made on the properties or production method of an appropriate sputtering target. If such a sintered body is used as a target, the Ga content of the thin film is significantly reduced by about two third of the Ga content of the target. This suggests that there are great variations in various properties including the composition in the target. However, no studies were made on the uniformity of the properties of the target.

As the preparation of a thin film transistor using the sputtering target has started on the practical basis, unlike the preparation of a silicon-based thin film transistor using the conventional plasma-enhanced chemical vapor deposition (PECVD) in which gas is supplied, by conducting sputtering for a long period of time using a single target, a problem of instability that, due to a change in properties of the resulting thin film, film-forming speed or the like, the thin film transistor performance is changed, minor adjustments of film-forming conditions are required or the like has come up to the surface. It has become clear that a semiconductor device, the representative example of which is a thin film transistor (TFT), is more likely to be affected greatly as compared to the case of formation of a transparent conductor film. As mentioned above, various studies are made on the target for forming an oxide thin film. When a film is formed by using a single target for a long period of time, properties of the resulting thin film and the stability of the performance of a thin film transistor are not considered.

Related Art Document

Prior Art Documents

Patent Document 1: JP-A-2007-73312
Patent Document 2: JP-A-2007-223849

Patent Document 3: WO2004/079038
Patent Document 4: Japanese Patent No. 3644647
Patent Document 5: WO2008/072486
Patent Document 6: JP-A-2008-53356

Summary of the Invention

An object of the invention is to provide a sputtering target which is capable of forming a thin film having stable properties even if long-term film formation is conducted.

In order to attain the above-mentioned object, the inventors made intensive studies. As a result, the inventors have found that the properties of a thin film obtained by a long-term film formation become unstable due to a change in properties (specific resistance or the like) of a target when sputtering is conducted for a long period of time. Further, the inventors have found that, in a sputtering target formed of indium oxide, zinc oxide and gallium oxide, when film formation is conducted for a long period of time, the shape of a crystal on the sputtering surface is changed (a change in crystal type), whereby the above-mentioned instability is caused.

So far, this problem did not come up to the surface in a sputtering target formed of indium oxide and tin oxide or a sputtering target formed of indium oxide and zinc oxide. The reason therefor is assumed to be that, due to the co-presence of gallium and zinc, various crystal types, including layered compounds, may be generated. It is assumed that, because of a difference in temperatures at which a crystal type is generated, the crystal type is varied by a change in composition ratio due to slight variations in conditions, evaporation of components or the like.

The inventors have found that the problem can be solved by selecting a production method or production conditions which are suited for obtaining a suitable composition ratio; for example, a shaped body having a relatively large thickness is heated at a slow heating rate to prepare a sintered body, and the surface of the thus obtained sintered body is sufficiently ground to form a target or conditions under which a crystal type which is adequate for each composition is generated are used.

The inventors have also found that, by using the thus prepared sputtering target in which the surface compound and the interior compound are essentially of the same crystal type (if there are two or more crystal types, the combination thereof is the same), the film-forming speed varies only slightly when film formation is conducted for a long period of time and a change in properties of a TFT prepared by using the resulting thin film can be suppressed. The invention has been made based on this finding.

The inventors have further found that, according to the invention, a difference in composition between the target and the thin film is reduced, whereby the problem that the Ga content of the thin film is significantly reduced as compared with the Ga content of the target can be solved.

According to the invention, the following sputtering target and the method for producing a sputtering target are provided.

1. A sputtering target comprising an oxide sintered body comprising In, Zn and Ga, wherein a surface compound and an interior compound are essentially of the same crystal type(s).

2. The sputtering target according to 1, wherein the ratio R1/R2 of the specific resistance (R1) of a surface and the specific resistance (R2) of a part which is deep by $t/2$ mm ($t$ is an average thickness of the sputtering garget) from the surface is 0.4 or more and 2.5 or less.

3. The sputtering target according to 1 or 2, wherein the composition ratio (atomic ratio) of In, Zn and Ga of the oxide sintered body satisfies any of the following regions 1 to 6:

Region 1

$$Ga/(In + Ga + Zn) \leqq 0.50$$

$$0.58 \leqq In/(In + Zn) \leqq 0.85$$

$$In/(In + Ga) \leqq 0.58$$

Region 2

$$Ga/(In + Ga + Zn) \leqq 0.50$$

$$0.20 \leqq In/(In + Zn) < 0.58$$

$$In/(In + Ga) \leqq 0.58$$

Region 3

$$0.20 < Ga/(In + Ga + Zn)$$

$$0.51 \leqq In/(In + Zn) \leqq 0.85$$

$$0.58 < In/(In + Ga)$$

Region 4

$$0.00 < Ga/(In + Ga + Zn) < 0.15$$

$$0.20 \leqq In/(In + Zn) < 0.51$$

$$0.58 < In/(In + Ga)$$

Region 5

$$0.00 < Ga/(In + Ga + Zn) \leqq 0.20$$

$$0.51 \leqq In/(In + Zn) \leqq 0.85$$

Region 6

$$0.15 \leqq Ga/(In + Ga + Zn)$$

$$In/(In + Zn) < 0.51$$

$$0.58 < In/(In + Ga)$$

4. The sputtering target according to 3, wherein the essentially same crystal type(s) is formed only of one crystal type.

5. The sputtering target according to 4, wherein the one crystal type is a homologous crystal structure represented by $In_2Ga_2ZnO_7$ and the oxide sintered body satisfies the composition ratio in the region 1.

6. The sputtering target according to 4, wherein the one crystal type is a homologous crystal structure represented by $InGaO_3(ZnO)$ and the oxide sintered body satisfies the composition ratio in the region 2 or the region 3.

7. The sputtering target according to 4, wherein the one crystal type is a crystal structure which has X-ray diffraction peaks of CuKα rays at 2θ of 7.0° to 8.4°, 30.6° to 32.0°, 33.8° to 35.8°, 53.5° to 56.5° and 56.5° to 59.5° and the oxide sintered body satisfies the composition ratio in the region 4.

8. The sputtering target according to 3, wherein the essentially same crystal type(s) comprises a spinel crystal structure represented by $ZnGa_2O_4$ and a bixbyite crystal structure represented by $In_2O_3$ and the oxide sintered body satisfies the composition ratio in the region 1 or the region 3.

9. The sputtering target according to 3, wherein the essentially same crystal type(s) comprises a crystal structure which has X-ray diffraction peaks of CuKα rays at 2θ of of 7.0° to 8.4°, 30.6° to 32.0°, 33.8° to 35.8°, 53.5° to 56.5° and 56.5° to 59.5° and a bixbyite crystal structure represented by $In_2O_3$, and the oxide sintered body satisfies the composition ratio in the region 5.

10. The sputtering target according to 3, wherein the essentially same crystal type(s) comprises a crystal structure which has X-ray diffraction peaks of CuKα rays at 2θ of 7.0° to 8.4°, 30.6° to 32.0°, 33.8° to 35.8°, 53.5° to 56.5° and 56.5° to 59.5° and a homologous crystal structure represented by $InGaO_3(ZnO)$, and the oxide sintered body satisfies the composition ratio in the region 6.

11. A method for producing the sputtering target according to any one of 4, 5, 6 and 8 which comprises the following steps (a) to (e) of:

(a) mixing raw material compound powder to prepare a mixture;
(b) shaping the mixture to prepare a shaped body having a thickness of 6.0 mm or more;
(c) heating the atmosphere at a heating rate of 3°C/min or less;
(d) sintering the heated shaped body at 1280°C or higher and 1520°C or lower for 2 hours or longer and 96 hours or shorter, thereby to obtain a sintered body having a thickness of 5.5 mm or more; and
(e) grinding a surface of the sintered body by 0.25 mm or more.

12. The method of producing the sputtering target according to 5, which comprises the following steps (a) to (e) of:

(a) mixing raw material compound powder to prepare a mixture;
(b) shaping the mixture to form a shaped body having a thickness of 6.0 mm or more;
(c) heating the atmosphere at a heating rate of 3°C/min or less;
(d) further sintering the heated shaped body at a temperature exceeding 1350°C and 1540°C or lower for 2 hours or longer and 36 hours or shorter, thereby to obtain a sintered body having a thickness of 5.5 mm or more; and
(e) grinding a surface of the sintered body by 0.25 mm or more.

13. The method for producing the sputtering target according to 8 which comprises the following steps (f) to (i) of:

(f) mixing raw material compound powder to prepare a mixture;
(g) shaping the mixture to prepare a shaped body;
(h) heating the atmosphere at a heating rate of 10°C/min or less; and
(i) further sintering the heated shaped body at a temperature of 1100°C or higher and 1350°C or lower for 4 hours or longer and 96 hours or shorter.

According to the invention, it is possible to provide a sputtering target which is excellent in stability of properties of a thin film obtained when a long-term film formation is conducted.

According to the invention, even if film formation is conducted for a long period of time, stable thin film transistor properties can be obtained.

Brief Description of the Drawings

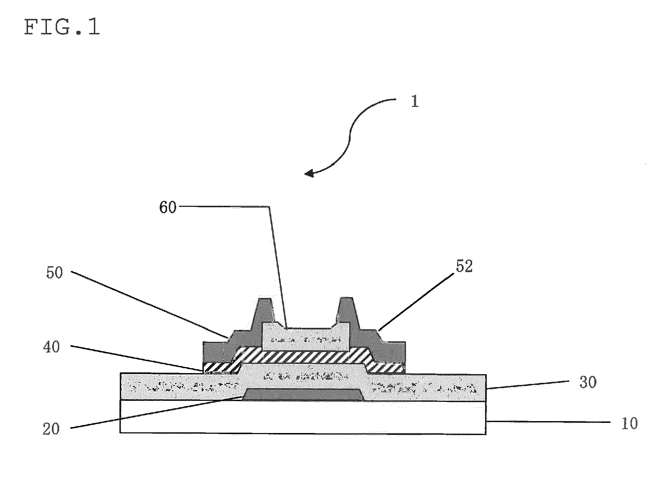

FIG. 1 is a diagrammatical view showing the structure of the channel-stopper type thin film transistor (inverse-staggered thin film transistor) according to the invention.

Mode for Carrying out the Invention

The sputtering target of the invention (hereinafter referred to as the target of the invention) comprises a sintered body containing In, Zn and Ga, wherein the surface and interior compounds are essentially of the same crystal type(s).

If the surface and interior compounds of a target are essentially of the same crystal type(s), when film formation is conducted for a long period of time by using a single target, the properties of the resulting thin film are not varied.

Here, the "essentially same" means that it suffices that the crystal types identified by the X-ray diffraction measurement (XRD) in the cutting planes of the surface and the interior are the same.

The fact that the surface and interior compounds are "essentially of the same crystal type" is judged by the following method. For example, if the average thickness is t mm, the surface is cut by t/2 mm from the surface. The crystal type of the surface compound and the crystal type of the compound of a part which is deep by t/2 mm from the surface is analyzed by the X-ray diffraction measurement (XRD),

The crystal structure of the surface of the sputtering target can be confirmed from the X-ray diffraction pattern which is obtained by measuring the target surface directly by X-ray diffraction.

The crystal structure of the deep part of the sputtering target can be formed by the following method. The target is cut parallel with respect to the surface, and the cutting surface obtained is directly confirmed by the X-ray diffraction, whereby the crystal structure can be confirmed from the X-ray diffraction pattern obtained.

The cutting method of the target is as follows, for example.

Apparatus: Million-Cutter 2 MC-503N manufactured by Maruto Instrument Co., Ltd.

Conditions: Diamond blade φ200 mm

Procedures:

 1. An plate (alumina plate) is heated, and adfix (adhesive: manufactured by Maruto Instrument Co., Ltd.) is applied thereon.
 2. After the target was placed, the absorbing plate was quenched by water, whereby the target is fixed.
 3. The absorbing plate was set to an apparatus, and the target is cut.
 4. The procedures 1 to 3 are repeated such that an arbitral ground surface is obtained.

The measuring conditions of the X-ray diffraction are as follows.

Apparatus: Ultima-III, manufactured by Rigaku Corporation

X rays: CuKα rays (wavelength:1.5406Å, monochromatized by means of a graphite monochrometer) 2θ-θ reflection method, continuous scanning (1.0°/min)

Sampling interval: 0.02°

Slit DS, SS: 2/3°, RS: 0.6 mm

Regarding the crystal type, as for those which are registered in JCPDS (Joint Committee of Powder Diffraction Standards) cards, identification can be made by referring to the JCPDS card.

If the structure is judged by the crystal structure X-ray diffraction pattern, the amount of oxygen may be excessive or insufficient (oxygen deficiency) (it may be in accordance with the stoichiometric ratio or may be deviated from the stoichiometric ratio). However, it is preferred that it have oxygen deficiency. If the amount of oxygen is excessive, the resistance may be too high if a target is formed by using this sintered body.

In the target of the invention, in addition to the similarity of the crystal type, if two or more crystal types are contained, it is preferred that the peak intensity ratio be almost the same. Comparison of the peak intensity ratio is conducted by using the maximum peak height ratio of each crystal type. The height of ratio the maximum peak is compared, if the difference is ± 30% or less, the crystal types are judged to be almost the same. A difference of ± 15% less is more preferable, with ± 5% or less being more particularly preferable.

If the difference in maximum peak height ratio is small, it is expected that the variation in properties of the thin film obtained can be suppressed when the target is used for a long period of time.

Within a range which does not impair the advantageous effects of the invention, the target of the invention may contain metal elements other than In, Ga and Zn mentioned above. For example, it may contain Sn, Ge, Si, Ti, Zr, Hf or the like.

In the invention, as for metal elements contained in the target, the target may comprise only In, Ga and Zn, or only In, Ga, Zn and Sn, without comprising elements other than impurities which are inevitably mixed in from a raw material or during the production process.

The crystal size on the target surface and the crystal size of a part which is deep by t/2 mm from the surface are preferably 20 μm or less, more preferably 10 μm or less, with 5 μm or less being particularly preferable.

If the crystal size on the surface and the crystal size at a deep part differs greatly, conditions under which abnormal discharge occurs may vary.

In the target of the invention, the ratio R1/R2 of the specific resistance (R1) on the surface and of the oxide sitered bodythe specific resistance (R2) of a part which is deep by t/2 mm from the surface is preferably 0.4 or more and 2.5 or less.

The R1/R2 is preferably 0.4 or more and 2.5 or less, more preferably 0.5 or more and 2 or less, with 0.67 or more and 1.5 or less being particularly preferable.

If the R1/R2 is less than 0.4 or exceeds 2.5, the properties (specific resistance or the like) of the target are varied between the initial stage of using the target and after the long-term use of the target (target is consumed), leading to instability that the film-forming speed is changed, the properties of the fabricated TFT are changed or the like.

In the target of the invention, it is preferred that the composition ratio (atomic ratio) of In, Zn and Ga of the oxide sintered body satisfy any of the following regions 1 to 6.
Region 1

$$Ga/(In + Ga + Zn) \leqq 0.50$$

$$0.58 \leqq In/(In + Zn) \leqq 0.85$$

$$In/(In + Ga) \leqq 0.58$$

Region 2

$$Ga/(In + Ga + Zn) \leqq 0.50$$

$$0.20 \leqq In/(In + Zn) < 0.58$$

$$In/(In + Ga) \leqq 0.58$$

Region 3

$$0.20 < Ga/(In + Ga + Zn)$$

$$0.51 \leqq In/(In + Zn) \leqq 0.85$$

$$0.58 < In/(In + Ga)$$

Region 4

$$0.00 < Ga/(In + Ga + Zn) < 0.15$$

$$0.20 \leqq In/(In + Zn) < 0.51$$

$$0.58 < In/(In + Ga)$$

Region 5

$$0.00 < Ga/(In + Ga + Zn) \leqq 0.20$$

$$0.51 \leqq In/(In + Zn) \leqq 0.85$$

Region 6

$$0.15 \leqq Ga/(In + Ga + Zn)$$

$$In/(In + Zn) < 0.51$$

$$0.58 < In/(In + Ga)$$

More preferred ranges of each region are as follows.

Region 1

$$Ga/(In + Ga + Zn) \leqq 0.45$$

$$0.58 \leqq In/(In + Zn) \leqq 0.80$$

$$In/(In + Ga) \leqq 0.56$$

Region 2

$$Ga/(In + Ga + Zn) \leqq 0.40$$

$$0.35 \leqq In/(In + Zn) < 0.58$$

$$In/(In + Ga) \leqq 0.58$$

Region 3

$$0.20 < Ga/(In + Ga + Zn)$$

$$0.60 \leqq In/(In + Zn) \leqq 0.85$$

$$0.60 < In/(In + Ga)$$

Region 4

$$0.09 < Ga/(In + Ga + Zn) < 0.15$$

$$0.35 \leqq In/(In + Zn) < 0.48$$

$$0.58 < In/(In + Ga)$$

Region 5

$$0.09 < Ga/(In + Ga + Zn) \leqq 0.20$$

$$0.53 \leqq In/(In + Zn) \leqq 0.75$$

Region 6

$$0.17 \leqq Ga/(In + Ga + Zn)$$

$$0.35 \leqq In/(In + Zn) < 0.48$$

$$0.60 < In/(In + Ga)$$

A further preferable range of the region 6 is as follows.
Region 6

$$0.18 < Ga/(In + Ga + Zn)$$

$$0.38 < Zn/(In + Ga + Zn) \leqq 0.50$$

$$0.35 \leqq In/(In + Zn) < 0.48$$

$$0.60 < In/(In + Ga)$$

The properties of each region are as follows.

Region 1:    It is possible to fabricate a TFT which has a small photocurrent.
It is to fabricate a TFT which has a high resistance to a mixed acid.
It is possible to fabricate a target which essentially comprises a single crystal type ($In_2Ga_2ZnO_7$).
In the region 1, it is possible to general a crystal type of $In_2Ga_2ZnO_7$ by adjusting preparation conditions such as sintering temperature or allowing a slight amount of a dopant such as Sn to be contained. Further, it is possible to allow an oxide sintered body in which other crystal types than $In_2Ga_2ZnO_7$ are not confirmed to be generated by XRD. Due to the presence of the crystal types of $In_2Ga_2ZnO_7$, conductivity can be enhanced by a layered structure.
In the region 1, by adjusting the fabrication conditions such as sintering temperature, crystal types such as $In_2O_3$ and $ZnGa_2O_4$ can be included. Due to the presence of the crystal type of $In_2O_3$ and $ZnGa_2O_4$, oxygen deficiency can be easily generated in $In_2O_3$ without conducting a heat treatment in a reducing atmosphere, whereby the specific resistance can be lowered. Due to the presence of this crystal type, the crystal type of the surface compound and the crystal type of the interior compound can easily coincide even when only slight grinding is conducted or even when grinding is not conducted. The reason therefor is assume to be the stability of this crystal type at relatively low temperatures.

Region 2:    It is possible to fabricate a TFT which has a relatively small photocurrent.
It is possible to fabricate a target which is essentially composed of a single crystal type ($InGaZnO_4$).

| | |
|---|---|
| Region 3: | It is possible to fabricate a TFT which has a relatively large mobility and a relatively small S value. When a TFT is fabricated, a small amount of photocurrent is flown. |
| | In the region 3, by adjusting the fabricating conditions such as sintering temperature, it is possible to allow the crystal type of $In_2O_3$ to be included. Due to the presence of the crystal type of $In_2O_3$, it is easy to allow oxygen deficiency to be generated in $In_2O_3$ without conducting a heat treatment in a reducing atmosphere, whereby the specific resistance can be lowered. |
| | In the region 3, even though the ratio of In and Ga is not 1:1, by adjusting the fabrication conditions such as the sintering temperature, the crystal type of a homologous structure represented by $In_2Ga_2ZnO_7$ or $InGaZnO_4$ can be generated easily. Due to the presence of the crystal type of a homologous structure, conductivity can be enhanced by a layered structure. |

| | |
|---|---|
| Region 4: | It is possible to fabricate a TFT having a large mobility and a small S value. It is to fabricate a target which is essentially composed of a single crystal type. |
| | It is easy to lower the specific resistance of the target. |
| | In the region 4, by adjusting the fabricating conditions such as the sintering temperature, it is possible to fabricate a target which is essentially formed of a single crystal type. By allowing the target to be formed of a single crystal type, uniformity of a target is improved. Further, conductivity is improved. |

| | |
|---|---|
| Region 5: | It is possible to fabricate a TFT which has a significantly large mobility and a small S value. |
| | It is easy to lower the specific resistance of the target. |
| | In the region 5, it is possible to fabricate a target comprising a crystal structure having X-ray diffraction peaks of CuKα rays at 2θ = 7.0° to 8.4°, 30.6° to 32.0°, 33.8° to 35.8°, 53.5° to 56.5. and 56.5° to 59.5° and a crystal type represented by $In_2O_3$. Due to the combination of these crystal types, oxygen deficiency can be generated in $In_2O_3$ easily, whereby the specific resistance can be lowered. |
| | Further, the sputtering target having the composition of the region 5 is preferable for obtaining a thin film transistor having a high mobility of which the semiconductor layer is a thin film. |

| | |
|---|---|
| Region 6: | It is possible to fabricate a TFT having a slightly large mobility and a small S value (a TFT which is more excellent in photocurrent, resistance to mixed acid and moisture resistance than one in the region 4). |
| | In the region 6, it is possible to fabricate a target comprising a crystal structure having X-ray diffraction peaks of CuKα rays at 2θ = 7.0° to 8.4°, 30.6° to 32.0°, 33.8° to 35.8°, 53.5° to 56.5° and 56.5° to 59.5° and a crystal type represented by $InGaZnO_4$. Due to the presence of a homologous structure, conductivity is improved. |

When a TFT is fabricated by using the target of the invention, reduction in photocurrent is expected when Ga/(In + Zn + Ga) is larger then 0. A larger Ga/(In + Zn + Ga) leads to a larger scale of reduction in photocurrent. Further, a Ga/(In + Zn + Ga) of 0.50 or less is preferable. A smaller Ga/(In + Zn + Ga) leads to improvement in mobility or S value.

When a TFT is fabricated by using the target of the invention, improvement in mobility can be expected when In/(In + Zn) is 0.20 or more. A larger In/(In + Zn) leads to improvement in mobility. Further, when a TFT is fabricated by using the target of the invention, the TFT can be easily adjusted to a normally-off state when an In/(In + Zn) is small, i.e. 0.80 or less.

When film formation is conducted by sputtering in the regions 1 and 2 where the Ga content is large, since a change in film-forming speed or carrier density is relatively sensitive to oxygen partial pressure, slight variations or unevenness may disturb uniformity of properties of the resulting thin film or may lower reproducibility. In respect of sensitivity of the film-forming speed or carrier density to a change in oxygen partial pressure, the regions 3 to 6 are preferable, with the regions 4 and 5 being particularly preferable.

The target of the invention may be formed essentially of essentially the same crystal type or one crystal type.

If the target is formed of one crystal type, improvement in uniformity or appearance (suppression of unevenness in color, black and white spots or the like) of the target properties can be expected. Further, the strength (transverse rupture strength or impact strength) of the target can be improved.

In the target of the invention, it is preferred that the one type of crystal type be a homologous crystal structure represented by $In_2Ga_2ZnO_7$ and satisfy the composition ratio in the above-mentioned region 1.

The crystal structure represented by $In_2Ga_2ZnO_7$ (or represented by $(InGaO_3)_2ZnO$ having a $(YbFeO_3)_2FeO$ crystal type is called the "hexagonal layered compound" or the "homologous phase crystal structure", and is a crystal type of a "super-lattice structure" having a long periodicity obtained by overlapping crystal layers of different substances. If the crystal periodicity or the thickness of each thin film layer is on about nanometer levels, by combination of the chemical composition of each layer or the thickness of the layer, properties which are different from those of a single material or those of a mixed crystal which is obtained by mixing each layer uniformly can be obtained. The crystal structure of the homologous can be confirmed, for example, by the fact that the X-ray diffraction pattern which is directly measured by the crushed or cut pieces of the target or the target itself coincides with the crystal structure X-ray diffraction pattern of the homologous phase assumed from the composition ratio. Specifically, it can be confirmed from the accordance with the crystal structure X-ray diffraction pattern of the homologous phase obtained from the JCPDS (Joint Committee of Powder Diffraction Standards) cards.

The crystal structure represented by $In_2Ga_2ZnO_7$ corresponds to JCPDS cards No. 38-1097.

This crystal type is easily obtained by including Sn (tin) in the following composition ratio (atomic ratio) in the region 1:

$0.005 < Sn/(In + Ga + Zn + Sn) < 0.10$

The above-mentioned Sn content is more preferably the following:

$0.01 < Sn/(In + Ga + Zn + Sn) < 0.05$

In order to obtain this crystal type (a homologous crystal structure represented by $In_2Ga_2ZnO_7$), the sintering temperature is preferably 1350°C to 1540°C, with 1380°C to 1500°C being more preferable.

In the target of the invention, it is preferred that the one crystal type be a homologous crystal structure represented by $InGaO_3(ZnO)$ and satisfy the composition ratio in the region 2 or the region 3.

The crystal structure represented by $InGaO_3(ZnO)_m$ (m is an integer of 1 to 20) is a "hexagonal layered compound" or a "homologous phase crystal structure".

The crystal structure represented by $InGaO_3(ZnO)$ is given in JCPDS card No.38-1104.

$InGaO_3(ZnO)$ is a case when m is 1 (m is an integer of 1 to 20) of $InGaO_3(ZnO)_m$, and it may be described as $InGaZnO_4$.

In the target of the invention, it is preferred that the one crystal type be a crystal structure which has X-ray diffraction peaks of CuKα rays at 2θ = 7.0° to 8.4°, 30.6° to 32.0°, 33.8° to 35.8°, 53.5° to 56.5° and 56.5° to 59.5° and the oxide sintered body satisfy the composition ratio in the region 4.

Oxide crystals of this crystal type are novel crystals which have not been confirmed yet, and are not stated in the JCPDS (Joint Committee of Powder Diffraction Standards) card.

The X-ray chart of the crystals of this oxide is similar to the crystal structure represented by $InGaO_3(ZnO)_2$ (JCPDS: 40-0252) and the crystal structure represented by $In_2O_3(ZnO)_2$ (JCPDS: 20-1442). However, the oxide of the invention has a peak specific to $InGaO_3(ZnO)_2$ (a peak in the above-mentioned region A), a peak specific to $In_2O_3(ZnO)_2$ (peaks in the above-mentioned regions D and E) and a peak which is not observed in $InGaO_3(ZnO)_2$ and $In_2O_3(ZnO)_2$ (the above-mentioned region B). Therefore, the oxide of the invention is different from $InGaO_3(ZnO)_2$ and $In_2O_3(ZnO)_2$,

This novel crystal structure is characterized in that it satisfies the following conditions 1.

In the chart obtained by the X-ray diffraction measurement (CuKα rays), diffraction peaks are observed in the following regions A to E.

Condition 1

A. Incident angle (2θ) = 7.0° to 8.4° (preferably 7.2° to 8.2°)
B. 2θ = 30.6° to 32.0° (preferably 30.8° to 31.8°)
C. 2θ = 33.8° to 35.8° (preferably 34.5° to 35.3°)
D. 2θ = 53.5° to 56.5° (preferably 54.1° to 56.1°)
E. 2θ = 56.5° to 59.5° (preferably 57.0° to 59.0°)

Further, it is preferred that the following conditions 2 be satisfied.

Condition 2

One of diffraction peaks observed at 2θ of 30.6° to 32.0° (the above-mentioned region B) and at 2θ of of 33.8° to 35.8° (the above-mentioned region C) is a main peak and the other is a sub peak. Here, the main peak means a peak of which the height of the maximum peak of the XRD pattern of the crystal type is the highest, and the sub peak means a peak of which the height of the maximum peak of the XRD pattern of the crystal type is the second highest.

In the target of the invention, the essentially same crystal type may be formed of two or more crystal types.

In the target of the invention, it is preferred that the essentially the same crystal type comprise the spinel crystal structure represented by $ZnGa_2O_3$ and a bixbyite crystal structure represented by $In_2O_3$, and the oxide sintered body satisfy the composition ratio represented by the region 1 or the region 3.

Due to the presence of the spinel crystal structure represented by $ZnGa_2O_4$, it is expected that generation of $Ga_2O_3$ as an insulator is suppressed. If $Ga_2O_3$ as an insulator is generated, abnormal discharge may occur frequently, the resistance of the target may increase or other problems may occur.

Due to the presence of a bixbyite structure represented by $In_2O_3$, a target having a low specific resistance can be produced easily without conducting a reduction treatment.

It is preferred that the oxygen content of the tissue having a large In content be lower than the oxygen content of other surrounding part. The oxygen content of each tissue can be confirmed by the composition distribution by an electron probe microanalyzer (EPMA),

The lattice constant a of the bixbyite structure represented by $In_2O_3$ be 10.14 or less, more preferably 10.10 or less, with 10.08 or less being particularly preferable. The lattice constant a is obtained by the XRD fitting. If the lattice constant is small, it is expected that the specific resistance can be lowered by improvement of mobility.

It is expected that this crystal type (including the spinel crystal structure and the bixbyite crystal structure) can be obtained by sintering at 1100°C to 1350°C or the like in the region 1 or the region 3.

If this crystal type can be generated, if the average thickness of the oxide sintered body is less than 5.5 mm or the surface of the sintered body is ground by less than 0.3 mm, a sputtering target of which the surface compound and the interior compound are essentially of the same crystal type may be produced.

In the target of the invention, it is preferred that the essentially same crystal type comprise a crystal structure having X-ray diffraction peaks of CuKα rays at 2θ = 7.0° to 8.4°, 30.6° to 32.0°, 33.8° to 35.8°, 53.5° to 56.5° and 56.5° to 59.5° and a bixbyite crystal structure represented by $In_2O_3$. It is also preferred that the composition ratio in the region 5 be satisfied.

Due to the presence of a bixbyite crystal structure represented by $In_2O_3$, it becomes possible to produce easily a target having a low specific resistance without conducting a reduction treatment.

It is preferred that the oxygen content of the tissue having a large In content be lower than the oxygen content of the other surrounding part. The oxygen content of each tissue can be confirmed by the composition distribution by an electron probe microanalyzer (EPMA).

The lattice constant a of the bixbyite structure represented by $In_2O_3$ is preferably 10.14 or less, more preferably 10.10 or less, with 10.08 or less being particularly preferable. The lattice constant a is obtained by the XRD fitting.

In the target of the invention, it is preferred that the substantially same crystal type comprise a crystal structure having X-ray diffraction peaks of CuKα rays at 2θ = 7.0° to 8.4°, 30.6° to 32.0°, 33.80 to 35.8°, 53.5° to 56.5° and 56.5° to 59.5° and a homologous crystal structure represented by $InGaO_3(ZnO)$, and the oxide sintered body satisfy the composition ratio in the above-mentioned region 6.

Due to the co-presence of a novel crystal type which is assumed to be the homologous crystal structure and the homologous crystal structure represented by $InGaO_3(ZnO)$, advantageous effects that the film-forming speed varies only slightly, the appearance is excellent with a small amount of white spots being generated, the transverse rupture strength is high, the abnormal discharge does not frequently occur or the like can be expected if the target of the invention is used.

Next, the first method for producing the sputtering target of the invetnion will be explained below (hereinafter referred to as the first production method of the invention).

The first production method of the invention is characterized in that it comprises the following steps (a) to (e) of:

(a) mixing raw material compound powder to prepare a mixture,
(b) shaping the mixture to prepare a shaped body having a thickness of 6.0 mm or more,
(c) heating the atmosphere at a heating rate of 3°C/min or less,
(d) sintering the heated shaped body at a temperature of 1280°C or more and 1520°C or less for 2 hours or longer and 96 hours or shorter to obtain a sintered body having a thickness of 5.5 mm or more, and
(e) grinding a surface of the sintered body by 0.25 mm or more.

The first production method of the invention as mentioned above is useful to produce, of the above-mentioned targets of the invention, a target in which the essentially same crystal type is formed only of one crystal type, and the one crystal type is a homologous crystal structure represented by $In_2Ga_2ZnO_7$ and the composition ratio in the region 1 is satisfied; a target in which the one crystal type is a homologous crystal structure represented by $InGaO_3(ZnO)$ and

the composition ratio in the region 2 is satisfied; a target in which the essentially same crystal type comprises a spinel crystal structure represented by $ZnGa_2O_3$ and a bixbyite crystal structure represented by $In_2O_3$ and the composition ratio in the region 1 or the region 3 is satisfied; and a target in which the essentially same crystal type has a crystal structure having X-ray diffraction peaks of CuK$\alpha$ rays at $2\theta = 7.0°$ to $8.4°$, $30.6°$ to $32.0°$, $33.8°$ to $35.8°$, $53.5°$ to $56.5°$ and $56.5°$ to $59.5°$ and a bixbiyte crystal structure represented by $In_2O_3$ and the composition ratio in the region 5 is satisfied.

The average thickness of the shaped body is normally 6.0 mm or more, and preferably 8 mm or more. If the average thickness is 6.0 mm or more, it is expected that the unevenness in temperature in the surface is decreased, whereby variations in crystal type between the surface compound and the interior compound hardly ocuur.

The heating rate is normally 3.0°C/min or less, preferably 2.5°C/min or less, with 1.5°C/min or less being particularly preferable. The lower limit of the heating rate is about 0.3°C/min. If the heating rate is slower than 0.3°C/min, the sintering may take a too long time, leading to an increase in cost.

If the heating rate exceeds 3°C/min, the crystal type may vary between the surface compound and the interior compound. The reason therefor is assumed to be unevenness in temperature or the like which occur in the thickness direction of the target at the time of heating.

The sintering temperature is normally 1280°C or higher and 1520°C or lower, and preferably 1300°C or higher and 1500°C or lower.

The sintering time is normally 2 hours or longer and 96 hours or shorter, preferably 4 hours or longer and 48 hours or shorter, more preferably 6 hours or longer and 24 hours or shorter.

The depth of the surface to be ground is normally 0.25 mm or more, preferably 0.3 mm or more, more preferably 0.5 mm or more, with 2 mm or more being particularly preferable. If the depth to be ground is less than 0.25 mm, the part in the vicinity of the surface where the crystal structure varies may not be fully removed.

The second production method of the invention is characterized in that it comprises the following steps (a) to (e) of :

(a) mixing the raw material compound powder to prepare a mixture,
(b) shaping the mixture to prepare a shaped body having a thickness of 6.0 mm or more,
(c) heating the atmosphere at a heating rate of 3°C/min or less,
(d) sintering the heated shaped body at a temperature exceeding 1350°C and 1540°C or lower for 2 hours or longer and 36 hours or shorter, thereby to obtain a sintered body having a thickness of 5.5 mm or more; and
(e) grinding a surface of the sintered body by 0.25 mm or more.

The second production method of the invention is useful for producing, of the above-mentioned targets of the invention, a target in which the essentially same crystal type comprises one crystal type and the one crystal type is a homologous crystal structure represented by $In_2Ga_2ZnO_7$ and the composition ratio in the region 1 is satisfied.

The sintering temperature is normally exceeding 1350°C and 1540°C or lower, preferably 1380°C to 1510°C, more preferably 1400°C to 1490°C. If the sintering temperature is 1350°C or lower or exceeds 1540°C, a crystal type other than the above-mentioned crystal type (the homologous crystal structure represented by $In_2Ga_2ZnO_7$) may be generated.

Further, the sintering time is normally 2 hours or longer and 36 hours or less, preferably 4 to 24 hours, with 8 to 12 hours being more preferable, If the sintering time exceeds 36 hours, a crystal type other than the above-mentioned crystal type (homologous crystal structure represented by $In_2Ga_2ZnO_7$) may be generated.

Explanation on other conditions is omitted here, since the other conditions are the same as those in the first production method of the invention.

The third production method of the invention is characterized in that it comprises the following steps (f) to (i) of :

(f) mixing raw material compound powder to prepare a mixture,
(g) shaping the mixture to prepare a shaped body,
(h) heating the shaped body at a heating rate of 10°C/min or less, and
(i) sintering the heated shaped body at a temperature exceeding 1100°C or higher and 1350°C or lower for 4 hours or longer and 96 hours or shorter.

The third production method of the invention is useful for producing, of the above-mentioned targets of the invention, a sputtering target in which the essentially same crystal type comprise the spinel crystal structure represented by $ZnGa_2O_3$ and the bixbyite crystal structure represented by $In_2O_3$ and the composition ratio in the region 1 or the region 3 is satisfied.

The heating rate is normally 10°C/min or less, preferably 6°C/min or less, more preferably 3°C/min or less. If the heating rate exceeds 10°C/min, the properties of the crystal type at the surface and the inside may vary or cracks may occur in the target. The lower limit of the heating rate is about 0.3°C/min.

The heating temperature is normally 1100°C or more and 1350°C or lower, preferably 1200°C or more and 1300°C or lower. If the heating temperature is lower than 1100°C, the relative density may not be increased or sintering may take time. If the heating temperature exceeds 1350°C, other crystal types which are generated at high temperatures may be generated, and the above-mentioned crystal types (the spinel crystal structure represented by $ZnGa_2O_3$ and the bixbyite crystal structure represented by $In_2O_3$) may not be obtained stably.

The sintering time is normally 4 hours or longer and 96 hours or shorter, preferably 4 hours or more and 48 hours or shorter, and more preferably 6 hours or longer and 24 hours or shorter. If the sintering time is shorter than 4 hours, the relative density may not be increased. If the sintering time is longer than 96 hours, part of the composition is evaporated, whereby the composition ratio may be varied. In addition, the production may take too long a period of time, leading to a difficulty in industrialization.

Explanation on other conditions is omitted here, since the other conditions are the same as those in the first or second production method of the invention.

<Explantion on each step of target production>

(1) Mixing step

A mixing step is a step of mixing metal oxides as a raw material of a sputteimg target.

As the raw material, powder such as powder of an indium compound, powder of a gallium compound, powder of a zinc compound or the like are used. The specific surface area (BET specific surface area) of each metal compound of the raw material of the target can be measured by a method stated in JIS Z 8830. As the indium compound, indium oxide, indium hydroxide or the like can be given, for example. As the gallium compound, gallium oxide, gallium hydroxide or the like can be given, for example. As the zinc compound, zinc oxide, zinc hydroxide or the like can be for for example. As each compound, is preferable since is and a bi-product hardly remains. In addition, as part of the raw material, it preferable to use metal zinc (zinc powder). By using zinc powder) as the raw generation of it can be

The purity of the raw material is normally 2N (99 mass%) or more, preferably 3N (99.9 mass%) or and particularly preferably 4N (99.99 or more. If the purity is lower than 2N, the of the the resulting thin film may be lowered or burning may occur due to entrance of impurities to the liquid crystal when used as a liquid crystal display.

It is that the raw materials such as metal oxides are for the production of a target be mixed, and homogenously and pulverized by means of a normal mixing pulveriser such as a wet ball mill, a beads mill or a ultrasonic apparatus.

(2) Pre-firing step

A pre-firing step is a step optionally provided in which a mixture of the compounds as the raw material of a sputtering target is pre-fired.
By the pre-firing step, the density of the can be easily increased, the production cost may also be increased. Therefore, it is more preferred that the density be increased without conducting pre-firing.

In the pre-firing step, it is preferred that the above-mentioned of metal oxides be heat-treated at 500 to 1200°C for 1 to 100 hours. If a heat treatment is conducted at less than 500°C or for shorter than 1 hour, thermal decomposition of an indium compound, a zinc compound or a tin compound maybe insufficient. If the heat treatment is conducted at a temperature higher than 1200°C or for longer that 100 hours, of particles may occur.
Therefore, it is particularly preferred that a heat treatment (pre-firing) be conducted at a temperature range of 800 to 1200°C for 2 to 50 hours.

It is preferred that a pre-fired product obtained in this step be the following shaping and firing steps.

(3) Shaping step

A shaping step is a step in which the mixture of metal oxides (the pre-fired if the above-mentioned pre-firing step is provided) is shaped under pressure, thereby to obtain a shaped product. By this step, the mixture or the pre-fired product is shaped into a shape which is suited for a target. If the pre-firing step is provided, after granulating fine powder of the resulting pre-fired the granulated product can be press-shaped into a desired shape.

As for the shaping treatment can be used in this step, press molding (uniaxial pressing), die molding, cast molding, injection our the like can be mentioned, for example. In order to obtain a sinter body (target) having a high sintered density, it is preferable to conduct shaping by cold isostatic pressing (CIP), or the like.
Further, after press shaping (uniaxial pressing), it is preferable to conduct cold isostatic pressing (CIP), hot isostatic pressing (HIP) or the like, i.e. to provide two or more steps of shaping, since reproducibility is enhanced.

When CIP (cold isostatic pressing or hydrostatic pressure apparatus) is used, it is preferable to hold at a surface pressure of 800 to 4000 kgf/cm$^2$ for 0.5 to 60 minutes. It is more preferable to hold at a surface pressure of 2000 to 3000

EP 2 503 019 A1

kgf/cm$^2$ for 2 to 30 minutes. Further, if the surface pressure is less than 800 kgf/cm$^2$, the density after sintering may not be increased or the resistance may be increased. If the surface pressure exceeds 4000 kgf/cm$^2$, the apparatus may become too large two an economical disadvantage. If the holding time is shorter than 0.5 minute, the density after sintering may not be increased or the resistance may become high. A holding time of 60 or longer may be economically disadvantageous since a too long period of time is taken.

In the shaping treatment, a shaping aid such as polyvinyl alcohol, methyl cellulose, polywax, oleic acid or the like may be used.

(4) Sintering step

A sintering step is a if which a shaped body obtained in the above-mentioned shaping step is fired.

For the sintering conditions, it is preferred that sintering be conducted in an oxygen gas atmosphere or under an oxygen gas pressure. If sintering is Conducted in an atmosphere which not contain a sufficient amount of oxygen gas, the density of the resulting target cannot be increase sufficiently, whereby occurrence of abnormal discharge during sputtering not be fully suppressed.

At the time of sintering, heating is conducted at the above-mentioned predetermined heating rate in the atmosphere. In addition, heating may be stopped the heating to allow the shaped body to be held at a holding temperature, whereby sintering may be conducted in two or more stages.

The temperature-lowering rate (cooling rate) in the atmosphere during firing is normally 4°C/min or less, preferably 2°C/min or less, more preferably 1°C/min or less, further preferably 0.8°C/min or less, and particularly preferably 0.5°C/min or less.

If the rate is 4°C/min or less, the crystal type of the invention can be easily obtained. Further, cracks hardly occur during the cooling.

(5) Reduction step

A reduction step is a step which is optionally provided according to need in order to decrease the bulk resistance of the sintered product obtained in the above-mentioned firing step in the entire target.

At for the reduction method can be applied in this step, reduction using a gas, reduction by firing, reduction with an inert gas or the like can be given.

In the of a reduction treatment with a reductive gas, hydrogen, methane, carbon monoxide or a gas with these and oxygen or the like can be used.

In the of a reduction treatment with an inert gas, nitrogen, razz mixed gas with these and or like can be used.

In the invention, it is that a reduction treatment (a heat treatment in an atmosphere of an inert gas such as argon and nitrogen, a hydrogen atmosphere or under vacuum or at a low pressure) be not conducted. If a reduction treatment is conducted, a in resistance value in a surface part and a deep part may be generated or amplified.

(6) Processing step

A processing step is a step which is optionally provided according to in order to cut the above-mentioned sintered into a shape its for on a sputtering apparatus, as s well as to provide a mounting jig a backing plate.

In order to form an oxide sintered body to be a sputtering target material, it is preferred that the sintered body be ground by means of a plane to allow the surface roughness Raw to be 5 $\mu$m or less. It is preferred the surface roughness Ra of the target material be 0.5 $\mu$m or and have a around surface having no directivity. If Ra is larger than 0.5 $\mu$m or the ground surface has directivity, abnormal discharge may occur or particles be generated.

the sputtering of the target may be subjected to mirror finishing, thereby allowing the average surface roughness thereof Ra to be 1000□ or less. For this mirror finishing (polishing), known polishing techniques such as mechanical polishing, chemical polishing, mechano-chemical polishing (combination of mechanical polishing and chemical polishing) or the like may be used. For example, it can be obtained by polishing by means of a fixed abrasive polisher (polishing liquid: water) to attain a roughness of #2000 or more, or can be obtained by a process in which, after lapping by a free abrasive lap (polisher: SiC paste or the like), lapping is conducted by using diamond as a polisher instead of the SiC paste.

It is preferable to finish the surface by means of a #200 to #10,000 diamond wheel, particularly preferably by means of a #400 to #5,000 diamond wheel. If a diamond with a size of smaller than #200 or a diamond wheel with a mesh of larger than #10,000 is the target may be broken easily.

There are no specific restrictions on these polishing methods. The resulting sputtering target is to a backing plate.

The thickness of the target is normally 2 to 20 mm, preferably 3 to 12 mm and particularly preferably 4 to 6 mm. A of target materials may be provided in a single backing plate to be used as a substantially single target.

Next, for cleaning, air blowing, washing with running water or the like can be When foreign are removed by air blowing, foreign can be removed more by air intake. by means of a dust collector from the side opposite to the nozzle. Since the above-mentioned air blow or washing with running water has its limit, ultrasonic cleaning or the like can also be conducted. In ultrasonic cleaning, it is effective to conduct multiplex oscillation within a frequency range of 25 to 300 KHz. For example, it is preferable to perform ultrasonic cleaning in a frequency range of 25 to 300 KHz by subjecting 12 kinds of frequency composed of every 25 kHz to multiplex oscillation.

The composition ratio (atomic ratio) of of the thus prepared target can be obtained by an analysis by means of an inductively coupled plasma atomic emission spectrometer (ICP-AES).

EXAMPLES

Hereinbelow, the invention will be explained in more detail with reference to the following examples, which should not be construed as limiting the scope of the invention.

Example 1

(1) Preparation of a target

Two or more same oxide sintered bodies were produced at the same time under the following conditions. One was used for a breakage test (cut and evaluated).

(a) Raw material
$In_2O_3$ Purity 4N, manufactured by Nippon Rare Metal, Inc.
$Ga_2O_3$ Purity 4N, manufactured by Nippon Rare Metal, Inc.
ZnO Purity 4N, manufactured by Kojundo Chemical Laboratory Co., Ltd.
(b) Mixing: Raw materials were mixed for 24 hours by means of a ball mill.
(c) Granulation: Natural drying
(d) Shaping:
Press shaping, surface pressure 400 kgf/cm$^2$, holding for 1 minute
CIP (cold isostatic pressing apparatus), surface pressure 2200 kgf/cm$^2$, holding for 5 minute
(e) Sintering: Electric furnace
Heating rate: 1°C/min
Sintering temperature: 1300°C
Sintering time: 20 hours
Sintering atmosphere: Oxygen atmosphere
Cooling rate: 0.3°C/min
(f) Post-treatment: No heat treatment was conducted under reduction conditions.
(g) Processing: A sintering body with a thickness of 6 mm was ground and polished to have a thickness of 5 mm.

The upper and lower surfaces and the corners were cut by means of a diamond cutter. The surface was ground by a plane grinder, whereby a target material having a surface roughness Ra of 5 $\mu$m or less was obtained.

(h) One of the resulting sintered bodies for a target was cut, for measuring the depth, at a part with a thickness of 2.5 mm.

(i) The surface of the resulting sintered body for a target was subjected to air blowing, followed by ultrasonic cleaning for 3 minutes. Thereafter, the sintered body was bonded to an oxygen-free copper backing plate by means of indium solder, whereby a target was produced. The target had a Surface roughness Ra of 0.5 $\mu$m or less, and had a ground surface having no directivity.

(2) Evaluation of a sintered body for a target

The resulting sintered body for a target was evaluated by the following methods.

(a) Specific resistance

Measured according to the four probe method (JIS R1637) by means of a resistivity meter (Loresta, manufactured by Mitsubishi Chemical Analytech Co., Ltd.). The average value of specific resistance values at 10 points is taken as the specific resistance value. From the specific resistance (R1) of the surface compound and the specific resistance (R2) of the interior compound of the resulting oxide body for a target, the ratio (R1/R2) was calculated.

(b) X-ray diffraction measurement (XRD)

The sintered oxide body for a target were directly measured under the following conditions, thereby to determine the crystal form.
Apparatus: "Ultima-III" manufactured by Rigaku Corporation
X-rays: CuKα rays (wavelength: 1.5406Å, monochromatized using a graphite monochrometer)
2θ-θ reflection method, continuous scan (1.0°/min)
Sampling interval: 0.02°
Slit DS, SS: 2/3°, RS: 0.6 mm
The crystal type of the compound contained in the oxide sintered body was determined by referring to the JCPDS card shown in Table 3.

(c) Paritcle size (μm)

The particle size of the oxide crystal is measured by an electron probe microanalyzer (EPMA) and shown in Table 1 in terms of average particle diameter.

(d) Composition ratio (atomic ratio)

A sample was collected from the target, analyzed by means of an inductively coupled plasma atomic emission spectrometer (ICP-AES) to obtain an atomic ratio.
Regarding the smilarity of the crystal type, as for the crystal type identified by XRD, a case where there is no crystal type contained only in one (all of the indentified crystal types conincide) is judged to be "the same", and a case there is a crystal type contained only in one is judge to be "not the same" (if the former is satisfied, crystal types which differ in peak intensity (about $\pm 50\%$) was to be the same).
Further, regarding the similarity of the elemental composition ratio (atomic ratio) of the surface and interior compounds of the sintered body for a target, a difference within $\pm 0.01$ for each metal element was judged to be the same.
Regarding the similarity of the particle size of the surface and interior compounds of the sintered body for a target, a case where the both particle sizes are within 5 μm was judged to be the same.
The similarity of the specific resistance of the surface and interior compounds of the sintered body for a target, a case where a difference is within $\pm 50\%$ was judged to be the same.
The similarity of the elemental composition ratio, a sample was collected from the surface and interior (the surface after cutting) compounds and analyzed by the ICP analysis method to compare the composition ratio (atomic ratio).

(3) Preparation of a TFT

Using the sputtering target thus obtained, a channel stopper thin film transistor (inverse-staggered thin film transistor) shown in FIG. 1 was prepared and evaluated.
As a substrate 10, a glass substrate (Corning 1737) was used. First, on the substrate 10, a 10 nm-thick Mo film, a 80 nm-thick Al film and a 10 nm-thick Mo film were sequentially stacked. The stacked film was formed into a gate electrode 20 by the photolithography method and the lift-off method.
On the gate electrode 20 and the substrate 10, a 200 nm-thick $SiO_2$ film was formed by the TEOS-CVD method to form a gate-insulating layer 30. The gate-insulating layer may be formed by the sputtering method. However, it is preferred that the gate-insulating layer be formed by a CVD method such as the TEOS (tetraethoxysilane)-CVD method or the plasma-enhanced chemical vapor deposition (PECVD) method. If the gate insulating layer is formed by the sputtering method, the off current may be increased.
Subsequently, by the RF sputtering method, by using the target prepared in (1) above, 50 nm-thick semicondutor film 40 (channel layer) was formed. Thereafter, the film was subjected to a heat treatment in the air at 300°C for 60 minutes.
On the semiconductor film 40, an $SiO_2$ film was deposited by the sputtering method as an etching stopper layer 60 (protective film). The protective film may be formed by the CVD method.
In this example, input RF power was 200 W. The atmosphere during film formation was 0.4 Pa (total pressure), and the gas flow ratio at this time was $Ar:O_2=95:5$. The substrate temperature was 50°C. The thus deposited oxide semiconductor film and the protective film were processed into an appropriate size by the photolithographic method and the etching method.
After forming the etching stopper layer 60, a 5 nm-thick Mo film, a 50 nm-thick Al film and a 5 nm-thick Mo film were stacked in this sequence, and a source electrode 50 and a drain electrode 52 were formed by the photolithographic method and dry etching.

Thereafter, a heat treatment was conducted in the atmosphere at 300°C for 60 minutes, whereby a transistor with a channel length of 20 μm and a channel width of 20 μm was obtained.

(4) Evaluation of a TFT

The thin film transistor was evaluated as follows.

(a) Mobility (field effect mobility (μ))

Mobility was measured by means of a semiconductor parameter analyzer (4200, manufactured by Keithley Instruments, Inc.) at room temperature in a light-shielded environment.

(b) S value (V/decade)

S value was measured by means of a semiconductor parameter analyzer (4200, manufactured by Keithley Instruments, Inc.) at room temperature in a light-shielded environment.

(c) Resistance to a mixed acid

(i) Preparation of a simple device for evaluating resistance to a mixed acid

A simple device was prepared by using a shadow mask. To a silicon substrate provided with a thermally-oxidized film (100 nm), a shadow mask for forming a semiconductor layer was attached. A semiconductor film was formed under the same conditions as (3) mentioned above. Then, a shadow mask for forming source/drain electrodes were attached, a gold electrode was formed by sputtering to form source/drain electrodes, whereby a simple device (TFT) for evaluating resistance to a mixed acid having a channel length (L) of 200 μm and a channel width (W) of 1000 μm was prepared.

(ii) Evaluation of resistance to a mixed acid

The simple device (TFT) for evaluating resistance to a mixed acid of which the driving was confirmed was immersed in 10 seconds in a mixed acid (an aqueous phosphoric acid-based solution, 30°C). Thereafter, the device was dried by blowing dry air at 150°C for 15 minutes, and then TFT properties were evaluated. Evaluation was conducted in two stages; a device in which a drain current (Id) of $10^{-6}$A or more at a gate voltage (Vg) of 15V and a drain voltage (Vd) of 15V could be confirmed was evaluated as A, and a device in which a drain current (Id) of $10^{-6}$A or more at a gate voltage (Vg) of 15V and a drain voltage (Vd) of 15V could not be confirmed was evaluated as B.

(d) Evaluation of photocurrent

A photocurrent under a light-irradiated environment and a photocurrent under a light-shielded environment were compared. Evaluation was conducted in two stages; i.e. a thin film transistor which suffered a variation in threshold voltage (Vth) of less than 2V was evaluated as A and a thin film transistor which suffered a variation in threshold voltage (Vth) of 2V or more was evaluated as B.

(5) Evaluation of stability of a sputtering target when used for a long period of time

(a) Stability (variation) of film-forming speed

The film-forming speed before and after the 1000-hour continous discharge (film formation) was compared. A variation of less than 5% was evaluated as A, a variation of 5% or more and less than 10% was evaluated as B and a variation of 10% or more was evaluated as C.

The film-forming speed was obtained by dividing the film thickness measured by means of a Stylus surface shape measuring device Dectak (manufactured by Ulvac, Inc.) by the film-forming time.

(b) Stability of TFT properties (variation)

A TFT was prepared before and after the 1000-hour continuous discharge (film formation), variation of TFT properties (on current) was evaluated. A variation of less than 10% was evaluated as A, a variation of 10% or more and less than 20% was evaluated as B and a variation of 20% or more was evaluated as C.

(6) Others

By the measurement of the composition distribution by means of an electron probe microanalyzer (EPMA), it it could be confirmed that, both at the surface and in the deep inside, the indium-rich part had a smaller oxygen content than that in the surrounding part.
By using the thin film formed in the same way, difference in composition ratio from the target was evaluated. The composition ratio was obained by analyzing the ICP analysis method. The composition ratio of the target and that of the thin film were almost the same (the composition ratio of each element of the thin film was Within $\pm$ 2% of the composition ratio of each element in the target).

Examples 2 to 9 and Comparative Examples 1 to 8

Oxide sintered bodies, sputtering targets and TFTs were prepared and evaluated in the same manner as in Example 1, except that the composition and conditions were changed to those shown in Tables 2-1 and 2-2. The resutls are shown in Tables 2-1 and 2-2.
The Sn comopund used in Example 3 and Reference Examples 1 to 3, 5 and 6, given later, was as follows.
$SnO_2$ Purity 4N, manufactured by Kojundo Chemical Laboratory Co., Ltd.
In Example 8, the lattice constant a of the bixbyite structure of $In_2O_3$ obtained by XRD was a=10.074.

Examples 10 and 11

When a semiconductor film was formed in a thickenss of 50 nm, the TFT became in the normally-on state. Therefore, a TFT was prepared by using a semiconductor film with a thickness of 15 nm. Oxide sintered bodies, sputtering targets and TFTs were prepared and evaluated in the same manner as in Example 1, except that the thickness of the semiconductor film was allowed to be 15 nm and the composition and conditions shown in Table 2-1 were used. The resutls are shown in Table 2-1.
Meanwhile, by the measurement by EPMA, it could be confirmed that, both on the surface and in the interior part, the tissue having a larger In content in Examples 10 and 11 had a small oxygen content than that in the surronding part. Further, by the measurement by EPMA, both on the surface and in the interior part, the tissue having a large In content in Example 3 had a larger tin (Sn) content than that in the surrounding part.

Reference Examples 1 to 6

Table 2-3 shows a referfence example of the sintered body which did not contain Ga. It can be confirmed that a sintered body having no Ga hardly suffers from a variation of the crystal type in the thickness direction of the target. From the results, the subject of the invention, i.e., the long-term stabiity, becomes more important in a sintered body containing Ga (in the case of a sputtering target containing indium oxide, gallium oxide and zinc oxide as raw materials).
The elemental composition ratio (atomic ratio), the particle size and the specific resistance of the sintered body for a target prepared in Example 1 and Comparative Example 1 are shown in Table 1.
Various properties or the like of the sintered bodies for a target and the TFTs prepared in Exampes, Comparative Examples and Referance Examples are shown in Tables 2-1 to 2-3. The "□" in the crystal type of the target means components contained in a small amount (impurity components; the height of the main peak is 50% or less of the height of the main peak of the main component).
Relationship of the crystal type and the JCPDS card No. is shown in Table 3.
Table 1

| Properties of target | | Example 1 | | | Com. Ex. 1 | | | |
|---|---|---|---|---|---|---|---|---|
| | | Depth from the surface(mm) | | Judgment | Depth from the surface(mm) | | Judgment | |
| | | 0.00 Surface | 2.50 Interior | | 0.00 Surface | 2.50 Interior | | |
| Elemental composition ratio (Atomic ratio) | In/ (In+Ga+Zn) | 0.401 | 0.400 | Same | 0.419 | 0.400 | Not the same | Within ±0.01 is judged to be the same |
| | Ga/ (In+Ga+Zn) | 0.401 | 0.400 | Same | 0.417 | 0.400 | Not the same | Within ±0.01 is judged to be the same |
| | Zn/ (In+Ga+Zn) | 0.198 | 0.200 | Same | 0.164 | 0.200 | Not the same | Within ±0.01 is judged to be the same |
| Particle size | | <5μm | <5μm | Same | 7μm | <5μm | Not the same | A case when both are less than 5μm is judged to be the same |
| Specific resistance (mΩ cm) | | 4.2 | 3.8 | Same | 5.8 | 28.0 | Not the same | Within ±50% is judged to be the same |

Table 2-1

| | | | Examples 1 | 2 | 3 | 4 | 5 | 6 | 7 | 8 | 9 | 10 | 11 |
|---|---|---|---|---|---|---|---|---|---|---|---|---|---|
| Production of target | Sintering conditions | Sintering atmosphere | Oxygen | Air | Oxygen | Air | Oxygen | Oxygen | Air | Air | Air | Oxygen | Oxygen |
| | | Heating rate(room temp. to 400°C)(°C/min) | 1.0 | 0.9 | 1.0 | 1.0 | 1.0 | 1.0 | 1.0 | 1.0 | 1.0 | 1.0 | 1.0 |
| | | Heating rate (400 to 1000°C)(°C/min) | 1.0 | 2.5 | 1.0 | 1.0 | 1.0 | 1.0 | 1.0 | 1.0 | 1.0 | 1.0 | 1.0 |
| | | Heating rate (1000°C to sintering temp.)(°C/min) | 1.0 | 5.0 | 1.0 | 1.0 | 1.0 | 1.0 | 1.0 | 1.0 | 1.0 | 1.0 | 1.0 |
| | | Sintering temp. (°C) | 1300 | 1300 | 1400 | 1400 | 1500 | 1500 | 1400 | 1400 | 1400 | 1400 | 1400 |
| | | Sintering hour (Hr) | 20 | 20 | 12 | 12 | 12 | 12 | 12 | 12 | 12 | 12 | 12 |
| | | Cooling rate (Sintering temperature to room temperatue) (°C/min) | 0.3 | Natural cooling | 0.3 | 0.3 | 0.3 | 0.3 | 0.3 | 0.3 | 0.3 | 0.3 | 0.3 |
| | Grinding | Thickness before grinding(mm) | 6.0 | 5.0 | 6.0 | 9.0 | 9.0 | 6.0 | 9.0 | 9.0 | 9.0 | 9.0 | 9.0 |
| | | Thickness after grinding (mm) | 5.0 | 5.0 | 5.0 | 5.0 | 5.0 | 5.0 | 5.0 | 5.0 | 5.0 | 5.0 | 5.0 |
| | | Depth of a part removed from the surface (mm) | 0.5 Grinding back and front | 0.0 — | 0.5 Grinding back and front | 2.0 Grinding back and front | 2.0 Grinding back and front | 0.5 Grinding back and front | 2.0 Grinding back and front | 2.0 Grinding back and front | 2.0 Grinding back and front | 2.0 Grinding back and front | 2.0 Grinding back and front |
| | | Reduction treatment (heat treatment in an argon atmosphere at 880°C for 2 hours) | None | None | None | None | None | None | None | None | None | None | None |
| Composition of target | Composition ratio (Atomic ratio) | In／(In+Ga+Zn) | 0.40 | 0.40 | 0.40 | 0.33 | 0.37 | 0.37 | 0.35 | 0.50 | 0.45 | 0.50 | 0.60 |
| | | Ga／(In+Ga+Zn) | 0.40 | 0.40 | 0.40 | 0.33 | 0.13 | 0.13 | 0.20 | 0.30 | 0.31 | 0.10 | 0.10 |
| | | Zn／(In+Ga+Zn) | 0.20 | 0.20 | 0.20 | 0.34 | 0.50 | 0.50 | 0.45 | 0.20 | 0.24 | 0.40 | 0.30 |
| | | Sn／(In+Ga+Zn+Sn) | 0.00 | 0.00 | 0.02 | 0.00 | 0.00 | 0.00 | 0.00 | 0.00 | 0.00 | 0.00 | 0.00 |
| | Region | | 1 | 1 | 1 | 2 | 4 | 4 | 6 | 3 | 3 | 5 | 5 |
| Crystal type of target | Surface | In₂O₃ | O | O | | | | | | O | O | O | O |
| | | ZnGa₂O₄ | O | O | | | | | | | | | |
| | | In₃Ga₂ZnO₇ | | | O | | | | | O | O | | |
| | | InGaZnO₄ | | | | O | | | O | O | O | | |
| | | SnO₂ | | | | | | | | | | | |
| | | In₂O₃(ZnO)ₖ | | | | | | | | | | | |
| | | Zn₂SnO₄ | | | | | | | | | | | |
| | | Novel crystal type | | | | | O | O | O | | | O | △ |
| | | Others | | △ | | | | | | | | | |
| | part deep by t/2 | In₂O₃ | O | O | | | | | | O | O | O | O |
| | | ZnGa₂O₄ | O | O | | | | | | | | | |
| | | In₃Ga₂ZnO₇ | | | O | | | | | O | O | | |
| | | InGaZnO₄ | | | | O | | | O | O | O | | |
| | | SnO₂ | | | | | | | | | | | |
| | | In₂O₃(ZnO)ₖ | | | | | | | | | | | |
| | | Zn₂SnO₄ | | | | | | | | | | | |
| | | Novel crystal type | | | | | O | O | O | | | O | △ |
| | | Others | | △ | | | | | | | | | |
| | Judgement of similarity | | Same | Same | Same | Same | Same | Same | Same | Same | Same | Same | Same |
| | Number of crystal types when the surface compound and the interior compound are essentially of the same crystal type | | Two or more | Two or more | One | One | One | One | Two or more | Two or more | Two or more | Two or more | Two or more |
| Specific resistance | Surface (mΩcm) | R1 | 4.2 | 4.9 | 3.2 | 8.3 | 3.6 | 3.3 | 5.9 | 7.8 | 8.1 | 3.8 | 3.6 |
| | Part deep by t/2 (mΩcm) | R2 | 3.4 | 3.6 | 2.6 | 8.6 | 2.8 | 2.4 | 5.4 | 7.4 | 7.8 | 3.3 | 3.2 |
| | Ratio (R1/R2) | | 1.24 | 1.36 | 1.23 | 0.97 | 1.29 | 1.38 | 1.09 | 1.05 | 1.04 | 1.15 | 1.13 |
| Evaluation | Evaluation of TFT | Mobility (cm²/Vs) | 8 | 8 | 8 | 10 | 20 | 20 | 16 | 14 | 14 | 28 | 32 |
| | | S value (V/decade) | 0.4 | 0.4 | 0.4 | 0.4 | 0.2 | 0.2 | 0.3 | 0.4 | 0.4 | 0.1 | 0.1 |
| | | Resistance to mixed acid | A | A | A | B | B | B | B | A | A | B | B |
| | | Photocurrent | A | A | A | A | B | B | B | A | A | B | B |
| | Stability when used for a long time | Stability of film-forming speed (variation) | A | A | A | A | A | A | A | A | A | A | A |
| | | Stability of TFT properteis (variation) | A | A | A | A | A | A | A | A | A | A | A |

## Table 2-2

| | | | Com. Ex. 1 | Com. Ex. 2 | Com. Ex. 3 | Com. Ex. 4 | Com. Ex. 5 | Com. Ex. 6 | Com. Ex. 7 | Com. Ex. 8 |
|---|---|---|---|---|---|---|---|---|---|---|
| Production of target | Sintering conditions | Sintering atmosphere | Air | Air | Air | Air | Air | Air | Air | Air |
| | | Heating rate (room temp. to 400 C)(°C/min) | 0.9 | 0.9 | 0.9 | 0.9 | 0.9 | 0.9 | 0.9 | 0.9 |
| | | Heating rate (400 to 1000°C)(°C/min) | 2.5 | 2.5 | 2.5 | 2.5 | 2.5 | 25 | 2.5 | 2.5 |
| | | Heating rate (1000°C to sintering temp.)(°C) | 50 | 5.0 | 5.0 | 5.0 | 5.0 | 5.0 | 5.0 | 5.0 |
| | | Sintering temp. (°C) | 1500 | 1400 | 1400 | 1400 | 1500 | 1300 | 1300 | 1500 |
| | | Sintering hour (Hr) | 20 | 2 | 2 | 20 | 20 | 20 | 20 | 20 |
| | | Cooling rate (Sintering temperature to room temperatue)(°C/min) | Natural cooling | Natural cooling | Natural cooling | Natural cooling | Natural cooling | Natural cooling | Natural cooling | Natural cooling |
| | Grinding | Thickness before grinding(mm) | 5.0 | 5.0 | 5.2 | 5.0 | 5.0 | 5.0 | 5.0 | 5.0 |
| | | Thickness after grinding (mm) | 5.0 | 5.0 | 5.0 | 5.0 | 5.0 | 5.0 | 5.0 | 5.0 |
| | | Depth of a part removed from the surface | 0.0 — | 0.0 — | 0.1 — | 0.0 — | 0.0 — | 0.0 — | 0.0 — | 0.0 — |
| | Reduction treatment (heat treatment in an argon atmosphere at 880 °C for 2 hours) | | None | Conducted | Conducted | None | None | None | None | None |
| Composition of target | Composition ratio (Atomic ratio) | In/(In+Ga+Zn) | 0.40 | 0.40 | 0.40 | 0.33 | 0.33 | 0.37 | 0.35 | 0.35 |
| | | Ga/(In+Ga+Zn) | 0.40 | 0.40 | 0.40 | 0.33 | 0.33 | 0.13 | 0.20 | 0.20 |
| | | Zn/(In+Ga+Zn) | 0.20 | 0.20 | 0.20 | 0.34 | 0.34 | 0.50 | 0.45 | 0.45 |
| | | Sn/(In+Ga+Zn+Sn) | 0.00 | 0.00 | 0.00 | 0.00 | 0.00 | 0.00 | 0.00 | 0.00 |
| | Region | | — | — | — | — | — | — | — | — |
| Crystal type of target | Surface | $In_2O_3$ | ○ | | | | ○ | ○ | | ○ |
| | | $ZnGa_2O_4$ | | | | | | | | |
| | | $In_2Ga_2ZnO_7$ | | ○ | ○ | | | | | |
| | | $InGaZnO_4$ | | | | ○ | | ○ | ○ | |
| | | $SnO_2$ | | | | | | | | |
| | | $In_2O_3(ZnO)_3$ | | | | | | | | |
| | | $Zn_2SnO_4$ | | | | | | | | |
| | | Novel crystal type | | | | | | △ | | |
| | | Others | | | | | | | | |
| | Part deep by t/2 | $In_2O_3$ | ○ | ○ | ○ | | | | | |
| | | $ZnGa_2O_4$ | ○ | ○ | ○ | | | | | |
| | | $In_2Ga_2ZnO_7$ | ○ | ○ | ○ | | | | | |
| | | $InGaZnO_4$ | | | | ○ | ○ | | ○ | ○ |
| | | $SnO_2$ | | | | | | | | |
| | | $In_2O_3(ZnO)_3$ | | | | | | | | |
| | | $Zn_2SnO_4$ | | | | | | | | |
| | | Novel crystal type | | | | | | ○ | ○ | ○ |
| | | Others | | | | | | | | |
| | Judgement of similarity | | Not the same | Not the same | Not the same | Not the same | Not the same | Not the same | Not the same | Not the same |
| | Number of crystal types when the surface compound and the interior compound are essentially of the same crystal type | | — | — | — | — | — | — | — | — |
| Specific resistance | Surface (mΩcm) | R1 | 5.8 | 4.8 | 5.2 | 4.1 | 25 | 28 | 28 | 5.8 |
| | Part deep by t/2 (mΩcm) | R2 | 14 | 22 | 18 | 12 | 12 | 4.3 | 13 | 13 |
| | Ratio (R1/R2) | | 0.41 | 0.22 | 0.29 | 0.34 | 2.08 | 6.51 | 2.15 | 0.45 |
| Evaluation | Evaluation of TFT | Mobility ($cm^2$/Vs) | 8 | 8 | 8 | 10 | 10 | 20 | 16 | 16 |
| | | S value (V/decade) | 0.4 | 0.4 | 0.4 | 0.4 | 0.4 | 0.2 | 0.3 | 0.3 |
| | | Resistance to mixed acid | A | A | A | B | B | B | B | B |
| | | Photocurrent | A | A | A | A | A | B | B | B |
| | Stability when used for a long time | Stability of film-forming speed (variation) | B | B | B | B | B | B | B | B |
| | | Stability of TFT properteis (variation) | B | B | B | B | B | B | B | B |

Table 2-3

| | | | Ref. Ex. | | | | | |
|---|---|---|---|---|---|---|---|---|
| | | | 1 | 2 | 3 | 4 | 5 | 6 |
| Production of target | Sintering conditions | Sintering atmosphere | Air | Air | Air | Air | Air | Air |
| | | Heating rate(room temp. to 400°C)(°C/min) | 0.9 | 0.9 | 0.9 | 0.9 | 0.9 | 0.9 |
| | | Heating rate (400 to 1000°C)(°C/min) | 2.5 | 2.5 | 2.5 | 2.5 | 2.5 | 2.5 |
| | | Heating rate (1000°C to sintering temp.)(°C/min) | 5.0 | 5.0 | 5.0 | 5.0 | 5.0 | 5.0 |
| | | Sintering temp. (°C) | 1300 | 1400 | 1500 | 1400 | 1400 | 1300 |
| | | Sintering hour (Hr) | 20 | 20 | 20 | 20 | 20 | 20 |
| | | Cooling rate (Sintering temperature to room temperatue)(°C/min) | Natural cooling | Natural cooling | Natural cooling | Natural cooling | Natural cooling | Natural cooling |
| | Grinding | Thickness before grinding(mm) | 5.0 | 5.0 | 5.0 | 5.0 | 5.0 | 5.0 |
| | | Thickness after grinding (mm) | 5.0 | 5.0 | 5.0 | 5.0 | 5.0 | 5.0 |
| | | Depth of a part removed from the surface (mm) | 0.0 — | 0.0 — | 0.0 — | 0.0 — | 0.0 — | 0.0 — |
| | Reduction treatment (heat treatment in an argon atmosphere at 880°C for 2 hours) | | None | None | None | None | None | None |
| Composition of target | Composition ratio (Atomic ratio) | In/(In+Ga+Zn) | 0.90 | 0.90 | 0.90 | 0.90 | — | 0.30 |
| | | Ga/(In+Ga+Zn) | — | — | — | — | — | — |
| | | Zn/(In+Ga+Zn) | — | — | — | 0.10 | 0.67 | 0.50 |
| | | Sn/(In+Ga+Zn+Sn) | 0.10 | 0.10 | 0.10 | — | 0.33 | 0.20 |
| | Region | | — | — | — | — | — | — |
| Crystal type of target | Surface | $In_2O_3$ | O | O | O | O | | O |
| | | $ZnGa_2O_4$ | | | | | | |
| | | $In_2Ga_2ZnO_7$ | | | | | | |
| | | $InGaZnO_4$ | | | | | | |
| | | $SnO_2$ | O | O | O | | | |
| | | $In_2O_3(ZnO)_3$ | | | | O | | |
| | | $Zn_2SnO_4$ | | | | | O | O |
| | | Novel crystal type | | | | | | |
| | | Others | | | | | | |
| | part deep by t/2 | $In_2O_3$ | O | O | O | O | | O |
| | | $ZnGa_2O_4$ | | | | | | |
| | | $In_2Ga_2ZnO_7$ | | | | | | |
| | | $InGaZnO_4$ | | | | | | |
| | | $SnO_2$ | O | O | O | | | |
| | | $In_2O_3(ZnO)_3$ | | | | O | | |
| | | $Zn_2SnO_4$ | | | | | O | O |
| | | Novel crystal type | | | | | | |
| | | Others | | | | | | |
| | Judgement of similarity | | Same | Same | Same | Same | Same | Same |
| | Number of crystal types when the surface compound and the interior compound are essentially of the same crystal type | | Two or more | Two or more | Two or more | Two or more | One | Two or more |
| Specific resistance | Surface (mΩcm) | R1 | | | | | | |
| | A part deep by t/2 (mΩcm) | R2 | | | | | | |
| | Ratio (R1/R2) | | | | | | | |
| Evaluation | Evaluation of TFT | Mobility ($cm^2$/Vs) | | | | | | |
| | | S value (V/decade) | | | | | | |
| | | Resistance to mixed acid | | | | | | |
| | | Photocurrent | | | | | | |
| | Stability when used for a long time | Stability of film-forming speed (variation) | | | | | | |
| | | Stability of TFT properteis (variation) | | | | | | |

Table 3

| Crystal type | | JCPDS card No. |
|---|---|---|
| $In_2O_3$ | | 06-0416 |
| $ZnGa_2O_4$ | | 38-1240 |
| $In_2Ga_2ZnO_7$ | | 38-1097 |
| $InGaZnO_4$ | $InGaO_3(ZnO)(m=1)$ | 38-1104 |
| $SnO_2$ | | 41-1445 |
| $In_2O_3(ZnO)_3$ | $In_2O_3(ZnO)_3(m=3)$ | 20-1439 |

(continued)

| Crystal type | | JCPDS card No. |
|---|---|---|
| $Zn_2SnO_4$ | | 24-1470 |
| Novel crystal type ※ | | Not registered |
| Others | (Unidentified peaks) | - |
| ※ Novel crystal type: a crystal structure having X-ray diffraction peaks of CuKα rays at 2θ= 7.0° to 8.4°, 30.6° to 32.0°, 33.8° to 35.8°, 53.5° to 56.5° and 56.5° to 59.5°. | | |

Industrial Applicability

According to the invention, it is possible to provide a sputtering target which is excellent in stability of properties of the resulting thin film when film-formation is conducted for a long period of time.

According to the invetnion, it is possible to provide efficiently a thin film transistor which has stable TFT properties.

Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.

The documents described in the specification are incorporated herein by reference in its entirety.

**Claims**

1. A sputtering target comprising an oxide sintered body comprising In, Zn and Ga, wherein a surface compound and an interior compound are essentially of the same crystal type(s).

2. The sputtering target according to claim 1, wherein the ratio R1/R2 of the specific resistance (R1) of a surface and the specific resistance (R2) of a part which is deep by t/2 mm (t is an average thickness of the sputtering garget) from the surface is 0.4 or more and 2.5 or less.

3. The sputtering target according to claim 1 or 2, wherein the composition ratio (atomic ratio) of In, Zn and Ga of the oxide sintered body satisfies any of the following regions 1 to 6:

Region 1

$$Ga/(In + Ga + Zn) \leqq 0.50$$

$$0.58 \leqq In/(In + Zn) \leqq 0.85$$

$$In/(In + Ga) \leqq 0.58$$

Region 2

$$Ga/(In + Ga + Zn) \leqq 0.50$$

$$0.20 \leqq In/(In + Zn) < 0.58$$

$$In/(In + Ga) \leqq 0.58$$

Region 3

$$0.20 < Ga/(In + Ga + Zn)$$

$$0.51 \leqq In/(In + Zn) \leqq 0.85$$

$$0.58 < In/(In + Ga)$$

Region 4

$$0.00 < Ga/(In + Ga + Zn) < 0.15$$

$$0.20 \leqq In/(In + Zn) < 0.51$$

$$0.58 < In/(In + Ga)$$

Region 5

$$0.00 < Ga/(In + Ga + Zn) \leqq 0.20$$

$$0.51 \leqq In/(In + Zn) \leqq 0.85$$

Region 6

$$0.15 \leqq Ga/(In + Ga + Zn)$$

$$In/(In + Zn) < 0.51$$

$$0.58 < In/(In + Ga)$$

4. The sputtering target according to claim 3, wherein the essentially same crystal type(s) is formed only of one crystal type.

5. The sputtering target according to claim 4, wherein the one crystal type is a homologous crystal structure represented by $In_2Ga_2ZnO_7$ and the oxide sintered body satisfies the composition ratio in the region 1.

6. The sputtering target according to claim 4, wherein the one crystal type is a homologous crystal structure represented by $InGaO_3(ZnO)$ and the oxide sintered body satisfies the composition ratio in the region 2 or the region 3.

7. The sputtering target according to claim 4, wherein the one crystal type is a crystal structure which has X-ray diffraction peaks of CuKα rays at 2θ of 7.0° to 8.4°, 30.6° to 32.0°, 33.8° to 35.8°, 53.5° to 56.5° and 56.5° to 59.5° and the oxide sintered body satisfies the composition ratio in the region 4.

8. The sputtering target according to claim 3, wherein the essentially same crystal type(s) comprises a spinel crystal structure represented by $ZnGa_2O_4$ and a bixbyite crystal structure represented by $In_2O_3$ and the oxide sintered body satisfies the composition ratio in the region 1 or the region 3.

9. The sputtering target according to claim 3, wherein the essentially same crystal type(s) comprises a crystal structure which has X-ray diffraction peaks of CuKα rays at 2θ of 7.0° to 8.4°, 30.6° to 32.0°, 33.8° to 35.8°, 53.5° to 56.5° and 56.5° to 59.5° and a bixbyite crystal structure represented by $In_2O_3$, and the oxide sintered body satisfies the composition ratio in the region 5.

10. The sputtering target according to claim 3, wherein the essentially same crystal type(s) comprises a crystal structure which has X-ray diflraction peaks of CuKα rays at 2θ of 7.0° to 8.4°, 30.6° to 32.0°, 33.8° to 35.8°, 53.5° to 56.5° and 56.5 to 59.5° and a homologous crystal structure represented by $InGaO_3(ZnO)$, and the oxide sintered body satisfies the composition ratio in the region 6.

11. A method for producing the sputtering target according to any one of claims 4, 5, 6 and 8 which comprises the following steps (a) to (e) of:

   (a) mixing raw material compound powder to prepare a mixture;
   (b) shaping the mixture to prepare a shaped body having a thickness of 6.0 mm or more;
   (c) heating the atmosphere at a heating rate of 3°C/min or less;
   (d) sintering the heated shaped body at 1280°C or higher and 1520°C or lower for 2 hours or longer and 96 hours or shorter, thereby to obtain a sintered body having a thickness of 5.5 mm or more; and
   (e) grinding a surface of the sintered body by 0.25 mm or more.

12. The method of producing the sputtering target according to claim 5, which comprises the following steps (a) to (e) of:

   (a) mixing raw material compound powder to prepare a mixture;
   (b) shaping the mixture to form a shaped body having a thickness of 6.0 mm or more;
   (c) heating the atmosphere at a heating rate of 3°C/min or less;
   (d) further sintering the heated shaped body at a temperature exceeding 1350°C and 1540°C or lower for 2 hours or longer and 36 hours or shorter, thereby to obtain a sintered body having a thickness of 5.5 mm or more; and
   (e) grinding a surface of the sintered body by 0.25 mm or more.

13. The method for producing the sputtering target according to claim 8 which comprises the following steps (f) to (i) of:

   (f) mixing raw material compound powder to prepare a mixture;
   (g) shaping the mixture to prepare a shaped body;
   (h) heating the atmosphere at a heating rate of 10°C/min or less; and
   (i) further sintering the heated shaped body at a temperature of 1100°C or higher and 1350°C or lower for 4 hours or longer and 96 hours or shorter.

FIG.1

## INTERNATIONAL SEARCH REPORT

| | International application No. |
|---|---|
| | PCT/JP2010/006761 |

**A. CLASSIFICATION OF SUBJECT MATTER**
*C23C14/34*(2006.01)i, *C04B35/00*(2006.01)i, *H01L21/363*(2006.01)i

According to International Patent Classification (IPC) or to both national classification and IPC

**B. FIELDS SEARCHED**

Minimum documentation searched (classification system followed by classification symbols)
C23C14/34, C04B35/00, H01L21/363

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2010 |
| Kokai Jitsuyo Shinan Koho | 1971-2010 | Toroku Jitsuyo Shinan Koho | 1994-2010 |

Electronic data base consulted during the international search (name of data base and, where practicable, search terms used)
Science Direct, JSTPlus(JDreamII)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 11-302835 A (Sumitomo Metal Mining Co., Ltd.), 02 November 1999 (02.11.1999), examples 1, 42 (Family: none) | 1,2<br>3,4,6,8,11, 13 |
| X<br>Y | JP 11-256321 A (Sumitomo Metal Mining Co., Ltd.), 21 September 1999 (21.09.1999), examples 1, 5; table 1 (Family: none) | 1,2<br>3,4,6,8,11, 13 |
| Y | WO 2009/084537 A1 (Nippon Mining & Metals Co., Ltd.), 09 July 2009 (09.07.2009), paragraph [0060] & KR 10-2010-0094597 A | 3,4,6,11 |

| ☒ | Further documents are listed in the continuation of Box C. | ☐ | See patent family annex. |
|---|---|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 07 December, 2010 (07.12.10) | 21 December, 2010 (21.12.10) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
| --- |
| PCT/JP2010/006761 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP 2008-280216 A  (Idemitsu Kosan Co., Ltd.),<br>20 November 2008 (20.11.2008),<br>paragraphs [0041] to [0053]; table 1<br>& WO 2008/139654 A1     & CN 101663250 A<br>& KR 10-2010-0016406 A | 3,8,13 |
| A | JP 2008-285760 A  (Idemitsu Kosan Co., Ltd.),<br>27 November 2008 (27.11.2008),<br>paragraphs [0129] to [0130], [0133] to [0134];<br>table 8<br>& US 2004/0180217 A1     & US 2008/0308774 A1<br>& US 2004/0222089 A1     & EP 1422312 A1<br>& EP 1431414 A1          & CN 1545567 A<br>& KR 10-2009-0038941 A   & KR 10-2009-0094181 A<br>& CN 1558962 A | 5,7,9,10,12 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007073312 A
- JP 2007223849 A
- WO 2004079038 A
- JP 3644647 B
- WO 2008072486 A
- JP 2008053356 A